# EUROPÄISCHE PATENTSCHRIFT

(11) **EP 1 048 980 B1**
(45) Veröffentlichungstag und Bekanntmachung des Hinweises auf die Patenterteilung: **30.09.2009**
(21) Anmeldenummer: 00108380.7
(22) Anmeldetag: 17.04.2000
(51) Int. Cl.: G03F 7/004, G03F 7/09

(54) **Bottomresist**
Bottom resist
Couche de fond à partir d'une photoréserve

(30) Priorität: 28.04.1999 DE 19919392
(43) Veröffentlichungstag der Anmeldung: 02.11.2000
(73) Patentinhaber: Qimonda AG, 81739 München (DE)
(72) Erfinder: Hien, Stefan, Dr., 91058 Erlangen (DE); Sebald, Michael, Dr., 91085 Weisendorf (DE)
(74) Vertreter: Epping - Hermann - Fischer

(56) Entgegenhaltungen:
- EP-A- 0 534 273
- EP-A1- 0 542 008
- EP-A2- 0 813 114
- US-A- 5 580 695
- US-A- 5 595 855
- US-A- 5 629 135
- US-A- 5 648 196

## Beschreibung

Die Erfindung betrifft einen Bottomresist für die Zweilagentechnik

In der Mikroelektronik werden zur Planarisierung und optischen Entkopplung von Substraten Lacke eingesetzt. Dabei ist es erforderlich, daß diese Lacke mittels eines Schleuderverfahrens ("spin-coating") auf das Substrat aufgebracht und durch geeignete Verfahren ausgehärtet werden können. Darüber hinaus muß auch gewährleistet sein, daß die Lacke bei der Überlackung mit einem Photoresist, wie er für Belichtungen im tiefen UV (248 nm, 193 nm, 157 nm oder 126 nm) verwendet wird, unlöslich sind. Die in diesem Wellenlängenbereich bevorzugt eingesetzten Photoresists basieren auf dem Prinzip der sogenannten chemischen Verstärkung (siehe dazu beispielsweise: "Jpn. J. Appl. Phys.", Vol. 31 (1992) , Pt. 1, No. 12B, Seiten 4273 bis 4282). Dabei wirkt sich jedoch nachteilig aus, daß die Resists sehr empfindlich auf die Basizität bzw. Acidität des darunterliegenden Materials reagieren (siehe dazu beispielsweise: "TI Technical Journal", Vol. 14, No. 3, May-June 1997, Seiten 17 bis 23).

In der Einlagentechnik werden substratätzresistente Resists auf dünnen Antireflexschichten verwendet, wobei die Antireflexschichten eine möglichst niedrige Ätzresistenz bei der Substratätzung im Halogenplasma besitzen. Diese Materialien sollen gezielt optische Reflexionen übereinanderlagern und ein Interferenzmuster erzeugen, welches nach Entwicklung im oberen Resist zu vertikalen Strukturen führt. Diese dünnen Materialien (Dicke < 100 nm) sind zwar hinsichtlich der Acidität an chemisch verstärkte Resists angepaßt, für Anwendungen in der klassischen Zweilagentechnik ("thin film Imaging") sind sie aber, was die Ätzbeständigkeit anbetrifft, nicht geeignet.

Sogenannte Bottomresists, die an die Zweilagentechnik mit chemisch verstärkten Photoresists angepaßt sind, sind bislang nicht bekannt. Ein in der Praxis bei der I-line-Technologie (Belichtung bei 365 nm) eingesetzter sogenannter CARL-Resist (CARL = Chemical Amplification of Resist Lines) ist ein Resist auf Diazonaphthochinonbasis, der einige Minuten bei einer Temperatur von ca. 300°C getempert wird. Dieses Material kann jedoch - wegen des hohen Anteils an basischen Bestandteilen - nicht als Unterlage für chemisch verstärkte Resists dienen. Nach der Entwicklung verbleiben nämlich in den belichteten Bereichen inakzeptable Restschichten oder es erfolgt eine sogenannte Fußbildung ("footing"), d.h. die entwickelten Strukturen sind an der Grenzfläche zum darunterliegenden Bottomresist wesentlich breiter, und somit werden also nicht die gewünschten vertikalen Profile erzeugt.

Entsprechendes gilt für Negativresistsysteme, die mit Vernetzungsmitteln arbeiten, welche basische Gruppierungen, wie Stickstoffatome, besitzen. Derartige Negativresists sind darüber hinaus lediglich in wäßrig-alkalischen Entwicklern unlöslich, sie verfügen aber über keine ausreichende Unlöslichkeit und Quellresistenz im Lösemittel des aufzubringenden Topresists.

In der europäischen Öffenlegungsschrift EP 0 813 114 A2 wird eine lichtabsorbierende, vernetzte Zusammensetzung beschrieben, welche als Anti-Reflexion-Schutz verwendet werden kann. Die Zusammensetzung kann einen Binder, ein Vernetzungsmittel, einen Thermosäuregenerator, ein Netzmittel sowie ein Lösungsmittel umfassen. Als Thermosäuregenerator wird 2-Nitrobenzyltosylat oder Benzointosylat verwendet.

In der europäischen Offenlegungsschrift EP 0 542 008 A1 wird eine Zusammensetzung für eine Anti-Reflexion-Schutzschicht beschrieben. Diese kann einen Binder sowie ein thermisch aktives Vernetzungsmittel umfassen. Als Vernetzungsmittel werden beispielsweise Amin-Basen wie Benzoguanamin-Basen oder Melamin-Basen genannt.

Aufgabe der Erfindung ist es, einen Bottomresist für die Zweilagentechnik bereitzustellen, der einerseits über eine angepaßte Oberflächenacidität verfügt, um mit chemisch verstärkten Photoresists kompatibel zu sein, und andererseits eine hohe Stabilität in einem Halogenplasma aufweist, wie es zur Strukturierung des darunterliegenden Substrats, wie Silicium, eingesetzt wird.

Dies wird erfindungsgemäß durch einen Bottomresist erreicht, der folgende Komponenten enthält:
- ein phenolisches Basispolymer,
- eine thermoaktive Verbindung, die oberhalb einer Temperatur von 100°C eine Sulfonsäure freisetzt,
- ein Lösemittel,
wobei die thermoaktive Verbindung ausgewählt ist aus folgenden Verbindungsklassen:
- ein Oniumsalz der Struktur (1) R₂I⁺ X⁻, (2) R₂BzS⁺ X⁻, (3) R₂ArS⁺ X⁻, (4) RI⁺ArI⁺R 2X⁻ oder (5) R₂S⁺ArS⁺R₂ 2X⁻ ist,
wobei die Reste R unabhängig voneinander jeweils die Bedeutung C₁- bis C₁₂-Alkyl oder (C₆- bis C₁₄-Aryl)-CO-CH₂- haben oder - bei Oniumsalzen der Struktur (2), (3) und (5) - zwei Reste R zusammen eine Tetramethylen-Gruppierung bilden, und Ar die Bedeutung C₆- bis C₁₄-Aryl hat, wobei ein oder zwei C-Atome durch O, N oder S ersetzt sein können, und Bz die Bedeutung Benzyl hat,
- ein Benzylsulfonsäureester ausgewählt aus: Benzyl-p-toluolsulfonsäureester, p-Methoxybenzyl-camphersulfonsäureester, p-Cyanobenzyl-camphersulfonsäureester, Phenothiazinyl-methyl-p-toluolsulfonsäureester.

Der Anteil an Basispolymer beträgt vorteilhaft 8 bis 40 Masse-%, vorzugsweise 8 bis 15 Masse-%, und der Anteil an thermoaktiver Verbindung vorteilhaft 0,005 bis 4 Masse-%, vorzugsweise 0,02 bis 0,1 Masse-%, der Rest (zu 100 Masse-% ist Lösemittel.

Der Bottomresist nach der Erfindung ist maßgeschneidert für die chemisch verstärkte Zweilagentechnik, bei der ein dünner photoempfindlicher Resist über einer dicken planarisierenden, substratätzresistenten Schicht benutzt wird. Bei diesem Bottomresist erfolgt die Vernetzungsreaktion rein thermisch, und zwar bei relativ niedrigen Temperaturen (> 100°C) und innerhalb kurzer Zeit (< 90 s). Die Lagerstabilität des Bottomresists ist beispielsweise bei 40°C über einen Zeitraum von mindestens sechs Monaten gewährleistet. Das Basispolymer des Resists weist einen hohen Anteil an aromatischen Strukturen auf, was eine hohe Ätzstabilität mit sich bringt.

Der Bottomresist nach der Erfindung kann vorteilhaft zusätzelich eine oder mehrere der folgenden Komponenten enthalten:
- Vernetzungswirksame Verbindung (Gehalt: 0,005 bis 4 Masse-%):
   Damit erfolgt eine Beschleunigung der Vernetzung bzw. Aushärtung (der Schicht). Bevorzugt werden hierzu Verbindungen eingesetzt, die mindestens zwei Hydroxymethylgruppen besitzen, wie 2,6-Dihydroxymethyl-p-kresol.
- Basische Verbindung (Gehalt: 0,005 bis 4 Masse-%)
   Dadurch kann die Acidität der Oberfläche des Resistmaterials (nach dem Aushärten) weiter reduziert werden. Bevorzugt werden hierzu Pyrrolidon- und Piperidinderivate ein- gesetzt, beispielsweise N-Methylpyrrolidon.
- Photoaktive, thermisch bis 235°C stabile Verbindung, die bei Belichtung eine Sulfonsäure freisetzt (Gehalt: 0,005 bis 4 Masse-%):
   Dies dient dazu, um bei einer späteren Belichtung (in der Zweilagentechnik) eine Säure an der Grenzfläche von Bottomresist und Topresist zu generieren. Zu diesem Zweck werden bevorzugt Triarylsulfoniumsalze eingesetzt.
- Farbstoff (Gehalt: 0,025 bis 12 Masse-%):
   Damit kann die Absorption und der Brechungsindex des Resistmaterials eingestellt werden. Der Farbstoff besitzt bei der jeweiligen Belichtungswellenlänge einen ε-Wert > 10000. Vorzugsweise dient hierzu Hydroxymethylanthracen (Anthracenmethanol).
- Additive (Gehalt: 0,0001 bis 0,04 Masse-%):
   Dies können insbesondere Verlaufmittel (Ausgleichsmittel) sein. Durch ein derartiges Additiv werden die planarisierenden Eigenschaften des Resists unterstützt.

Die Anpassung des Bottomresists an einen Topresist ist aus folgenden Gründen gewährleistet:
1. Die Acidität kann durch geeignete Säuregeneratoren bzw. durch Zusatz von Basen eingestellt werden. Als Säuregeneratoren, die auch als Thermosäuregeneratoren bezeichnet werden können, dienen insbesondere solche Verbindungen, die sich zwischen 100 und 235°C thermisch zersetzen. Hierbei kann im Prinzip zwar auf eine größere Anzahl von an sich bekannten Verbindungen zurückgegriffen werden, diese Verbindungen sind jedoch chemisch so zu modifizieren, dass die thermische Stabilität reduziert wird und die generierte Säure die gewünschte Mobilität aufweist. Darüber hinaus ist auf die Löslichkeit zu achten und auch darauf, daß die Neigung zur Kristallisation (Partikelbildung) möglichst gering ist. Dies kann durch verschiedene chemische Substituenten, wie verzweigte Alkylgruppen, die als Lösungsvermittler fungieren, und durch geeignete Grundstrukturen realisiert werden.
2. Die optischen Parameter können durch Zusatz geeigneter Farbstoffe eingestellt werden. Dabei ist eine möglichst hohe Absorption bei der Belichtungswellenlänge und eine möglichst geringe Flüchtigkeit bei der Prozessierung wichtig. Idealerweise kann der Farbstoff gleichzeitig auch die Funktion einer vernetzungswirksamen Verbindung oder einer basischen Verbindung oder einer photoaktiven, thermisch stabilen Verbindung übernehmen oder mehrere dieser Funktionen zusammen. Ein geeigneter Farbstoff könnte sogar als thermoaktive Verbindung selbst dienen.
3. Die Aushärtung des Bottomresists erfolgt in der Weise, daß beim Aufbringen des Topresists keine Quelleffekte auftreten. Dies wird dadurch erreicht, daß einerseits das Basispolymer eine hohe Anzahl an chemisch reaktiven Gruppen besitzt und daß andererseits möglichst geringe Anteile an unverknüpften freien Bestandteilen vorliegen. Letzteres ist dann der Fall, wenn nach der Vernetzungsreaktion nur noch ein sehr geringer Anteil an niedermolekularen Verbindungen vorhanden ist.

Die Sulfonat-Anionen X⁻ und der Sulfonatrest X werden dabei vorzugsweise aus einer der folgenden Gruppen ausgewählt:
- lineare, verzweigte oder cyclische C₁- bis C₁₂-Alkylsulfonatgruppe, beispielsweise eine Hexadecylsulfonat-, Cyclohexansulfonat- oder Camphersulfonatgruppe;
- einfach, mehrfach oder perhalogenierte C₁- bis C₁₂-Alkylsulfonatgruppe, beispielsweise eine Trifluormethansulfonat-(Triflat-) oder Nonafluorbutansulfonatgruppe;
- ein- oder mehrfach halogenierte C₆- bis C₁₄-Arylsulfonatgruppe, beispielsweise eine Pentafluorbenzolsulfonatgruppe;
- ein- oder mehrfach mit einem Elektronenakzeptor substituierte C₆- bis C₁₄-Arylsulfonatgruppe, beispielsweise eine Dinitrobenzolsulfonatgruppe;
- ein- oder mehrfach mit einem C₁- bis C₄-Alkylrest substituierte C₆- bis C₁₄-Arylsulfonatgruppe, beispielsweise eine p-Toluolsulfonatgruppe.

Beispielhaft seien folgende thermoaktive Verbindungen genannt:
- Oniumsalze der Struktur (1):
   Dimethyliodonium-p-toluolsulfonat, Diethyliodoniumnonafluorbutansulfonat, Methyl-(phenylcarboxymethyl)-iodonium-p-toluolsulfonat und Methyl-(anthrylcarboxymethyl)-iodonium-nonofluorbutansulfonat.
- Oniumsalze der Struktur (2) und (3):
   Trimethylsulfonium-camphersulfonat, Dimethyl-(phenylcarboxymethyl)-sulfonium-p-toluolsulfonat, Benzylthiolaniumnonafluorbutansulfonat, p-Methoxybenzylthiolanium-triflat, p-Nitrobenzylthiolanium-triflat, Anthryl-dimethylsulfonium-triflat und Phenothiazinyl-dimethylsulfonium-triflat.
- Oniumsalze der Struktur (4) und (5):
   Hierbei kann der aromatische Rest Ar beispielsweise Bisphenyl oder Anthryl sein, wie bei Bis(methyliodonium)-9, 10-anthracen-bistriflat.

Beim Bottomresist nach der Erfindung ist das phenolische Basispolymer vorzugsweise ein Novolak oder ein Poly-p-hydroxystyrol. Weitere geeignete Basispolymere sind beispielsweise Polyimide und Polybenzoxazole, die jeweils phenolische OH-Gruppen besitzen. Im Allgemeinen weist beim Basispolymer - im Mittel - wenigstens jede dritte Monomereinheit eine OH-Gruppe auf.

Das Lösemittel ist vorzugsweise Propylenglykol-monomethyletheracetat (Methoxypropylacetat), Cyclopentanon, Cyclohexanon, γ-Butyrolacton, Ethyllactat oder ein Gemisch aus wenigstens zwei dieser Verbindungen. Allgemein können aber alle gängigen Photolack-Lösemittel eingesetzt werden.

Die Bottomresists nach der Erfindung werden mit ausgewählten Topresists kombiniert, insbesondere mit chemisch verstärkten CARL-Resists (siehe dazu: "Proc. SPIE", 1998, Vol. 3333, Seiten 154 bis 164). In diesem Zusammenhang spielt auch die Belichtungswellenlänge eine wichtige Rolle, weil die optischen Parameter, wie Real- und Imaginäranteil des Brechungsindex, von der Wellenlänge abhängig sind.

Anhand von Ausführungsbeispielen soll die Erfindung noch näher erläutert werden (GT = Gewichtsteil).

### Beispiel 1

### Herstellung eines vernetzbaren Bottomresists

Aus 15,5 GT Novolak, 1 GT Benzylthiolanium-nonafluorbutansulfonat (Thermosäure) und 83,5 GT Propylenglykol-monomethyletheracetat wird ein vernetzbarer Bottomresist hergestellt. Die anschließende Filtration über ein 0,2 µm-Feinstfilter ergibt eine gebrauchsfertige Lösung. Wird diese Lösung bei 23°C gelagert, so bleibt die Viskosität innerhalb eines Jahres konstant.

### Beispiel 2

### Herstellung einer vernetzten Bottomresistschicht

Durch Aufschleudern der Lösung nach Beispiel 1 auf eine Siliziumscheibe bei 2500 min⁻¹ und anschließendes Ausheizen bei 110°C/90 s und 225°C/90 s auf einer Heizplatte wird eine 0,5 µm dicke lichtabsorbierende Schicht erhalten, die gegenüber Cyclohexanon, Propylenglykol-monomethyletheracetat, Ethyllactat und anderen Resistlösemittel resistent ist.

### Beispiel 3

### Herstellung eines vernetzbaren Bottomresists

Aus 14,5 GT Novolak, 1 GT Benzylthiolanium-nonafluorbutansulfonat (Thermosäure), 1 GT 2,6-Dihydroxymethyl-p-kresol (vernetzungswirksame Verbindung) und 83,5 GT Propylenglykol-monomethyletheracetat wird ein vernetzbarer Bottomresist hergestellt. Die anschließende Filtration über ein 0,2 µm-Feinstfilter ergibt eine gebrauchsfertige Lösung. Wird diese Lösung bei 23°C gelagert, so bleibt die Viskosität innerhalb eines Jahres konstant.

### Beispiel 4

### Herstellung einer vernetzten Bottomresistschicht

Durch Aufschleudern der Lösung nach Beispiel 3 auf eine Siliziumscheibe bei 2500 min⁻¹ und anschließendes Ausheizen bei 110°C/90 s und 200°C/90 s auf einer Heizplatte wird eine 0,5 µm dicke lichtabsorbierende Schicht erhalten, die gegenüber Cyclohexanon, Propylenglykol-monomethyletheracetat, Ethyllactat und anderen Resistlösemittel resistent ist.

### Beispiel 5 (Vergleichsversuch)

### Herstellung eines vernetzbaren Bottomresists

Aus 16,5 GT Novolak und 83,5 GT Propylenglykol-monomethyletheracetat wird ein selbst vernetzbarer Bottomresist hergestellt. Die anschließende Filtration über ein 0,2 µm-Feinstfilter ergibt eine gebrauchsfertige Lösung.

### Beispiel 6

### Herstellung einer vernetzten Bottomresistschicht

Durch Aufschleudern der Lösung nach Beispiel 5 auf eine Siliziumscheibe bei 2500 min⁻¹ und anschließendes Ausheizen bei 110°C/90 s und 250°C/90 s auf einer Heizplatte wird eine 0,5 µm dicke lichtabsorbierende Schicht erhalten, die gegenüber Cyclohexanon, Propylenglykol-monomethyletheracetat, Ethyllactat und anderen Resistlösemittel resistent ist.

### Beispiel 7 (Vergleichsversuch)

### Herstellung eines säurehaltigen vernetzbaren Bottomresists

Aus 15,5 GT Novolak, 1 GT Nonafluorbutansulfonsäure (freie Säure) und 83,5 GT Propylenglykol-monomethyletheracetat wird ein vernetzbarer Bottomresist hergestellt. Die anschließende Filtration über ein 0,2 µm-Feinstfilter ergibt eine gebrauchsfertige Lösung. Wird diese Lösung bei 23°C gelagert, so verändert sich die Viskosität bereits nach wenigen Wochen deutlich.

### Beispiel 8

### Herstellung einer vernetzten Bottomresistschicht

Durch Aufschleudern der Lösung nach Beispiel 7 auf eine Siliziumscheibe bei 2500 bis 3000 min⁻¹ und anschließendes Ausheizen bei 110°C/90 s und 225°C/90 s auf einer Heizplatte wird eine 0,5 µm dicke lichtabsorbierende Schicht erhalten, die gegenüber Cyclohexanon, Propylenglykol-monomethyletheracetat, Ethyllactat und anderen Resistlösemittel resistent ist.

## Patentansprüche

1. Zusammensetzung zur Bildung eines Bottomresists für die Zweilagentechnik, enthaltend
- ein phenolisches Basispolymer,
- ein Lösemittel,
- eine thermoaktive Verbindung, die oberhalb einer Temperatur von 100°C eine Sulfonsäure freisetzt,
wobei die thermoaktive Verbindung ausgewählt ist aus folgenden Verbindungsklassen:
- ein Oniumsalz der Struktur (1) R₂I⁺ X⁻, (2) R₂BzS⁺ X⁻, (3) R₂ArS⁺ X⁻, (4) RI⁺ArI⁺R 2X⁻ oder (5) R₂S⁺ArS⁺R₂ 2X⁻ ist,
wobei die Reste R unabhängig voneinander jeweils die Bedeutung C₁ bis C₁₂-Alkyl oder (C₆- bis C₁₄-Aryl)-CO-CH₂-haben oder - bei Oniumsalzen der Struktur (2), (3) und (5) - zwei Reste R zusammen eine Tetramethylen-Gruppierung bilden, und Ar die Bedeutung C₆- bis C₁₄-Aryl hat, wobei ein oder zwei C-Atome durch O, N oder S ersetzt sein können, und Bz die Bedeutung Benzyl hat,
- ein Benzylsulfonsäureester ausgewählt aus: Benzyl-p-toluolsulfonsäureester, p-Methoxybenzyl-camphersulfonsäureester, p-Cyanobenzyl-camphersulfonsäureester, Phenothiazinyl-methyl-p-toluolsulfonsäureester.

2. Zusammensetzung zur Bildung eines Bottomresist nach Anspruch 1,
**dadurch gekennzeichnet, daß** X bzw. X⁻ folgende Bedeutung haben kann:
- eine lineare, verzweigte oder cyclische C₁ bis C₁₂-Alky sulfonatgruppe,
- eine einfach, mehrfach oder perhalogenierte C₁- bis C₁₂-Alkylsulfonatgruppe,
- eine ein- oder mehrfach halogenierte C₆- bis C₁₄-Arylsulfonatgruppe,
- eine ein- oder mehrfach mit einem Elektronenakzeptor substituierte C₆- bis C₁₉-Arylsulfonatgruppe,
- eine ein- oder mehrfach mit einem C₁- bis C₄-Alkylrest substituierte C₆- bis C₁₄-Arylsulfonatgruppe.

3. Zusammensetzung zur Bildung eines Bottomresist nach einem der Ansprüche 1 bis 2,
**dadurch gekennzeichnet, daß** das Basispolymer ein Novolak oder Poly-p-hydroxystyrol ist.

4. Zusammensetzung zur Bildung eines Bottomresist nach einem oder mehreren der Ansprüche 1 bis 3,
**dadurch gekennzeichnet, daß** er zusätzlich eine vernetzungswirksame Verbindung enthält, insbesondere eine Verbindung mit mindestens zwei Hydroxy- methylgruppen.

5. Zusammensetzung zur Bildung eines Bottomresist nach einem oder mehreren der Ansprüche 1 bis 4,
**dadurch gekennzeichnet, daß** er zusätzlich eine basische Verbindung enthält, insbesondere ein Pyrrolidon- oder Piperidinderivat.

6. Zusammensetzung zur Bildung eines Bottomresist nach einem oder mehreren der Ansprüche 1 bis 5,
**dadurch gekennzeichnet, daß** er zusätzlich eine photoaktive, thermisch bis 235 °C stabile Verbindung enthält, die bei Belichtung eine Sulfonsäure frei- setzt, insbesondere ein Triarylsulfoniumsalz.

7. Zusammensetzung zur Bildung eines Bottomresist nach einem oder mehreren der Ansprüche 1 bis 6,
**dadurch gekennzeichnet, daß** er zusätzlich einen Farbstoff enthält, insbesondere Hydroxymethylanthracen.

8. Zusammensetzung zur Bildung eines Bottomresist nach einem oder mehreren der Ansprüche 1 bis 7,
**dadurch gekennzeichnet, daß** er Additive enthält, insbesondere ein Verlaufmittel.

9. Zusammensetzung nach einem der vorherigen Ansprüche, bei der das phenolische Basispolymer bei Temperaturen > 100°C vernetzbar ist.

## Claims

1. A bottom resist for the two-layer technique, comprising
- a phenolic base polymer,
- a solvent,
- a thermoactive compound, releasing a sulfon acid at a temperature above 100°C,
wherein the thermoactive compound is one of the following groups:
- an onium salt of structure (1) R₂I⁺ X⁻, (2) R₂BzS⁺ X⁻, (3) R₂ArS⁺ X⁻, (4) RI⁺ArI⁺R 2X⁻ or (5) R₂S⁺ArS⁺R₂ 2X⁻,
wherein each radical R is independently selected from the group consisting of C₁ to C₁₂alkyl or (C₆ to C₁₄ aryl) -CO-CH₂- or - for onium salts of structure (2), (3) and (5) - two radicals R together form a tetramethylene and Ar is C₆ to C₁₄ aryl, wherein one or two carbon atoms can be replaced by O, N or S and Bz is benzyl,
- a benzylsulfonic ester selected from one of: benzyl-p-toluolsulfonic ester, p-methoxybenzyl-camphersulfonic ester, p-cyano-benzyl-camphersulfonic ester, phenothiazinyl-methyl-p-toluolsulfonic ester.

2. The bottom resist according to claim 1,
**characterized in that** X or X-, respectively, can be selected from the group consisting of:
- a linear, branched or cyclic C1 to C12 alkylsulfonate group,
- a mono-, poly- of perhalogenated C1 to C12 alkylsulfonate group,
- a mono- or polyhalogenated C1 to C12 arylsulfonate group,
- a C6 to C14 arylsulfonate group substituted by at least one electron acceptor,
- a C6 to C14 arylsulfonate group substituted by at least one C1 to C4 alkyl radical.

3. The bottom resist according to one of the claims 1 to 2,
**characterized in that**
the base polymer is a novolak or poly-p-hydroxystyrene.

4. The bottom resist according to one or several of the claims 1 to 3,
**characterized in that**
it additionally comprises a crosslinking-active compound, especially a compound having at least two hydroxymethyl groups.

5. The bottom resist according to one or several of the claims 1 to 4,
**characterized in that** it additionally comprises a basic compound, especially a pyrrolidone derivative or piperidine derivative.

6. The bottom resist according to one or several of the claims 1 to 5,
**characterized in that** it additionally comprises a photoactive compound which is thermally stable up to 235°C and releases a sulfonic acid when exposed to radiation, especially a triarylsulfonium salt.

7. The bottom resist according to one or several of the claims 1 to 6,
**characterized in that**
it additionally comprises a dye, especially hydroxymethylanthracene.

8. The bottom resist according to one or several of the claims 1 to 7,
**characterized in that**
it comprises additives, especially a flow control agent.

9. The bottom resist according to one of the previous claims,
wherein the phenolic base polymer can be crosslinked at temperatures exceeding 100°C.

## Revendications

1. Composition pour créer une épargne de bas pour la technologie à deux niveaux, contenant
- un polymère de base en phénol
- un solvant
- un composé thermoactif qui dégage un acide de sulfone au-dessus d'une température de 100°C, le composé thermoactif étant sélectionné des catégories de combinaison suivantes:
- un sel onium de la structure (1) R₂I⁺ X⁻, (2) R₂BzS⁺ X⁻ , (3) R₂ArS⁺ X⁻ , (4) RI⁺ArI⁺R 2X⁻ ou (5) R₂S⁺ArS⁺R₂ 2X⁻_{'} les restes R ayant chaque fois la signification C₁- à C₁₂-alkyle ou (C₆- à C₁₄-aryle) - CO-CH₂- indépendamment l'un de l'autre, ou - chez des sels onium de la structure (2), (3) et (5) - deux restes forment ensemble un groupement tétra méthylène, et Ar a la signification C₆- à C₁₄-aryle, un ou deux C-atomes pouvant être replacés par O, N ou S, et Bz ayant la signification benzyle,
- un ester d'acide de sulfone benzyle sélectionné de: un ester d'acide de sulfone benzyle-p-toluène, un ester d'acide de sulfone p-méthoxybenzyle-camphre, un ester d'acide de sulfone p-cyanobenzyle-camphre, un ester d'acide de sulfone phénothiazine-méthyle-p- toluène.

2. Composition pour créer une épargne de bas selon la revendication 1, **caractérisée en ce que** X ou X⁻ peuvent avoir la signification suivante :
- un groupe C₁- à C₁₂- de sulfone alkyle linéaire, ramifiée ou cyclique
- un groupe C₁- à C₁₂- de sulfone alkyle, halogéné une fois, plusieurs fois ou complètement
- un groupe C₆- à C₁₄- de sulfone alkyle, halogéné une fois ou plusieurs fois
- un groupe C₆- à C₁₄- de sulfone aryle, substitué une fois ou plusieurs fois par un accepteur d'électrons,
- un groupe C₆- à C₁₄- de sulfone aryle, substitué une fois ou plusieurs fois par un reste d'alkyle C₁- à C₄.

3. Composition pour créer une épargne de bas selon l'une des revendications 1 à 2, **caractérisé en ce que** le polymère de base est un novolak ou un poly-p-hydroxystrole.

4. Composition pour créer une épargne de bas selon l'une ou plusieurs des revendications 1 à 3, **caractérisé en ce qu'**elle contient en plus un composé efficace pour une réticulation, en particulier un composé avec au moins deux groupes de hydroxy-méthyle.

5. Composition pour créer une épargne de bas selon l'une ou plusieurs des revendications 1 à 4, **caractérisé en ce qu'**elle contient en plus un composé de base, en particulier un dérivé de pyrrolidone ou pipéridine.

6. Composition pour créer une épargne de bas selon l'une ou plusieurs des revendications 1 à 5, **caractérisé en ce qu'**elle contient en plus un composé photoactif, thermiquement stabile jusqu'à 235 °C, qui, quand exposé à la lumière, dégage un acide de sulfone, en particulier un sel de triarylsulfone.

7. Composition pour créer une épargne de bas selon l'une ou plusieurs des revendications 1 à 6, **caractérisé en ce qu'**elle contient en plus un colorant, en particulier hydroxy-méthyle-anthracène.

8. Composition pour créer une épargne de bas selon l'une ou plusieurs des revendications 1 à 7, **caractérisé en ce qu'**elle contient en plus des additifs, en particulier un produit d'écoulement.

9. Composition pour créer une épargne de bas selon l'une des revendications précédentes, le polymère de base en phénol étant apte à être réticulé par des températures > 100°C.
